(19) Europäisches Patentamt
European Patent Office
Office européen des brevets

(11) **EP 4 654 252 A1**

(12) **EUROPEAN PATENT APPLICATION**
published in accordance with Art. 153(4) EPC

(43) Date of publication:
**26.11.2025  Bulletin 2025/48**

(21) Application number: **24744537.2**

(22) Date of filing: **09.01.2024**

(51) International Patent Classification (IPC):
*H01L 21/66* (2006.01)   *G01R 31/26* (2020.01)
*G01R 31/28* (2006.01)

(52) Cooperative Patent Classification (CPC):
**G01R 31/26; G01R 31/28; H01L 22/00**

(86) International application number:
**PCT/JP2024/000189**

(87) International publication number:
**WO 2024/154614 (25.07.2024 Gazette 2024/30)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **16.01.2023  JP 2023004559**

(71) Applicant: **Tokyo Electron Limited**
**Tokyo 107-6325 (JP)**

(72) Inventors:
• **KASAI, Shigeru**
**Nirasaki City, Yamanashi 407-8511 (JP)**
• **AGAWA, Hiroaki**
**Nirasaki City, Yamanashi 407-0192 (JP)**

(74) Representative: **Hoffmann Eitle**
**Patent- und Rechtsanwälte PartmbB**
**Arabellastraße 30**
**81925 München (DE)**

(54) **INSPECTION SYSTEM AND TEMPERATURE CONTROL METHOD**

(57)    Provided are an inspection system and a temperature control method with which a substrate is inspected while temperature control is suitably performed. The inspection system inspects a substrate while performing temperature control by a temperature adjustment mechanism. The inspection system comprises: a substrate holding unit that holds the substrate; a detection unit that supplies an inspection power to an electrode of the substrate; and a control unit. The detection unit has a temperature estimation unit that estimates a bonding portion temperature of a bonding portion provided to the substrate. The control unit includes: a step for supplying the inspection power to the substrate; a step for obtaining information related to the bonding portion temperature after the supply of the inspection power has been stopped; a step for determining an offset temperature of the substrate holding unit on the basis of the information related to the bonding portion temperature; a step for adjusting the temperature of the substrate holding unit on the basis of a control temperature offset by the offset temperature; and a step for supplying the inspection power to the substrate after the temperature of the substrate holding unit has been adjusted, and inspecting the substrate.

*FIG.2*

## Description

## Technical Field

The present disclosure relates to an inspection system and a temperature control method.

## Background

Patent Document 1 discloses a power conversion device capable of detecting an inter-terminal voltage between a source terminal and a drain terminal during an on-period of a power transistor and estimating a junction temperature of the power transistor with high accuracy.

## Prior Art Documents

## Patent Documents

Patent Document 1: Japanese Laid-open Patent Publication No. 2019-122107

## Summary

## Problems to Be Resolved by the Invention

In one aspect, the present disclosure provides an inspection system for inspecting a substrate while appropriately performing temperature control and a temperature control method.

## Means for Solving the Problems

To solve the problems, in one embodiment, an inspection system configured to inspect a substrate while performing temperature control using a temperature control mechanism is provided. The inspection system comprises a substrate holder configured to hold the substrate, a detector configured to supply an inspection power to an electrode portion of the substrate, and a controller. The detector includes a temperature estimation part configured to estimate a junction temperature of a junction portion provided at the substrate. The controller includes supplying the inspection power to the substrate, acquiring information on the junction temperature after the supply of the inspection power is stopped, determining an offset temperature of the substrate holder based on the information on the junction temperature, adjusting the temperature of the substrate holder based on a control temperature offset by the offset temperature, and supplying the inspection power to the substrate to inspect the substrate after the temperature of the substrate holder is adjusted.

## Effect of the Invention

In one aspect, an inspection system for inspecting a substrate while appropriately performing temperature control and a temperature control method can be provided.

## Brief Description of the Drawings

FIG. 1 is an example of a perspective view of an inspection system.
FIG. 2 is an example of a configuration diagram of an inspection system.
FIG. 3 is an example of a plan view schematically showing a configuration of a substrate.
FIG. 4 is an example of a flowchart explaining temperature control in an inspection system.
FIG. 5 is an example of a graph showing temporal transition of an inspection power and an offset temperature of an electronic device.
FIG. 6 is an example of a graph showing temporal transition of an inspection power and an offset temperature of an electronic device before and after the completion of the inspection of an electronic device.

## Detailed Description

Hereinafter, various exemplary embodiments will be described in detail with reference to the accompanying drawings. Further, like reference numerals will be used for like or corresponding parts throughout the drawings.

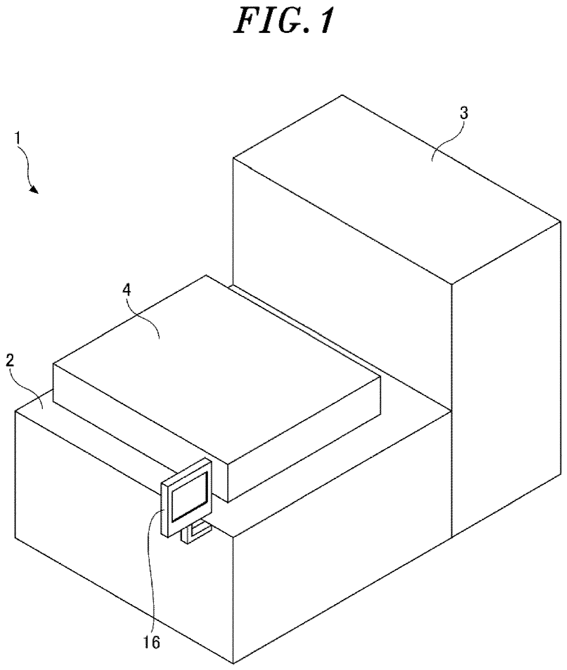

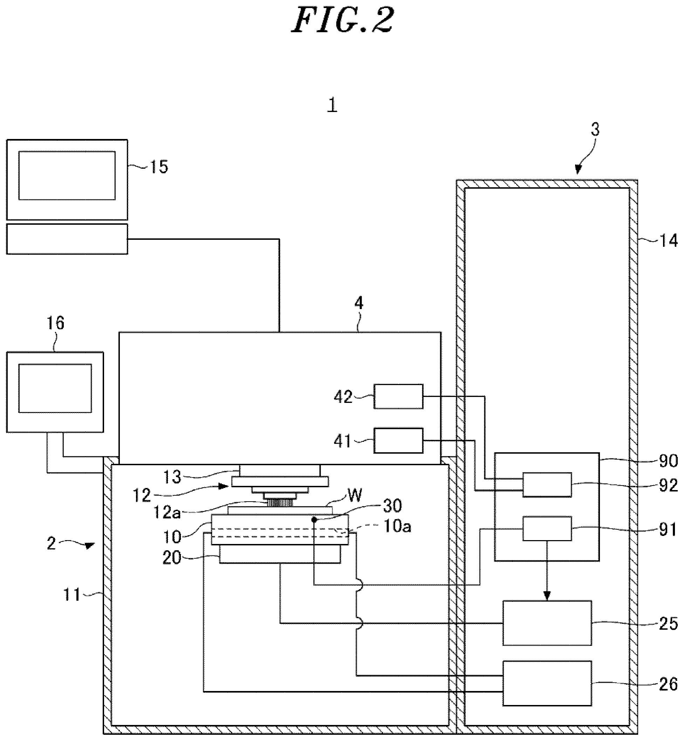

An inspection system 1, which is an example of an inspection system according to the present embodiment, will be described with reference to FIG. 1. FIG. 1 is an example of a perspective view of the inspection system 1. FIG. 2 is an example of a configuration diagram of the inspection system 1. Further, FIG. 2 is a partial cross-sectional view schematically showing components in the inspection system 1.

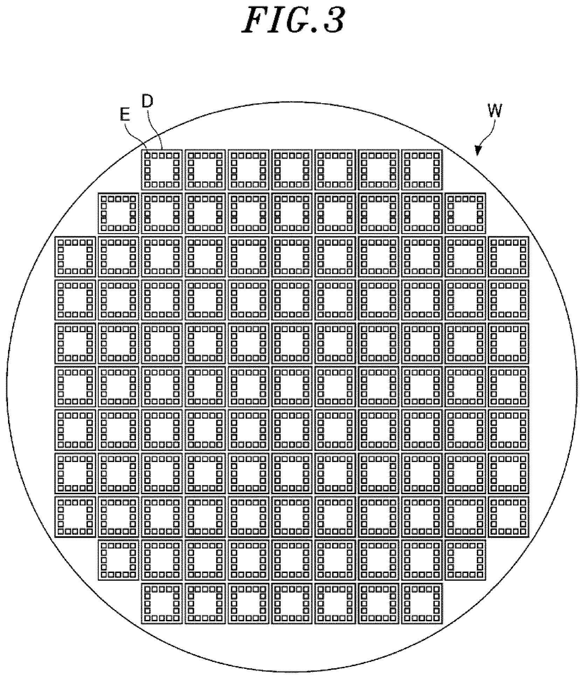

In a semiconductor manufacturing process, a plurality of electronic devices D (see FIG. 3 to be described later), each having a predetermined circuit pattern, are formed on a substrate W such as a semiconductor wafer or the like. Electrical characteristics of the electronic devices D formed on the substrate W are inspected and the electronic devices D are classified into non-defective products or defective products. The electronic devices D are inspected using the inspection system 1 before the substrate W is divided into the electronic devices D.

The inspection system 1 inspects the electrical characteristics of the plurality of electronic devices D (see FIG. 3 to be described later) formed on the substrate W while controlling a temperature. In other words, in the inspection system 1, an inspection power is supplied to the electronic devices D when the temperature of the electronic devices D is higher than or equal to a predetermined inspection temperature, and the electrical characteristics of the electronic devices D at that time are inspected.

The inspection system 1 includes an accommodating chamber 2, a loader 3, and a tester 4.

The accommodating chamber 2 has a hollow housing 11. In the housing 11, the accommodating chamber 2 has a stage (also referred to as "chuck") 10 on which the substrate W is placed. The stage 10 has an attraction holding portion (not shown) that attracts and holds the substrate W to prevent displacement of the position of the substrate W with respect to the stage 10. In the housing 11, the accommodating chamber 2 is provided with a moving mechanism (not shown) for moving the stage 10 in a horizontal direction and a vertical direction. The moving mechanism adjusts the relative positions of a probe card 12 to be described later and the substrate W, so that a desired electrode portion E (see FIG. 3 to be described later) on the surface of the substrate W can be brought into contact with probes 12a of the probe card 12.

The probe card 12 is provided in the housing 11 of the accommodating chamber 2. The probe card 12 is located above the stage 10 to face the stage 10. The probe card 12 has the plurality of needle-shaped probes 12a arranged to correspond to electrode pads or solder bumps provided to correspond to the electrode portions E of the electronic devices D of the substrate W. The probe card 12 is connected to the tester 4 via an interface 13. During the electrical characteristic inspection, the probes 12a are brought into contact with the electrode portions E of the electronic devices D of the substrate W, supply a power from the tester 4 to the electronic devices D via the interface 13, and transmit signals from the electronic devices D to the tester 4 via the interface 13.

A front opening unified pod (FOUP), which is a transfer container accommodating substrates W, is provided in the loader 3. The loader 3 has a transfer mechanism (not shown) for transferring the substrate W. The transfer mechanism takes out the substrate W accommodated in the FOUP and transfers it to the stage 10 of the accommodating chamber 2. Further, the transfer mechanism receives the substrate W for which the electrical characteristic inspection of the electronic devices D has been completed from the stage 10, and accommodates the substrate W it in the FOUP.

The tester 4 has a test board (not shown) for reproducing a part of the circuit configuration of the motherboard on which the electronic devices D are mounted. The test board of the tester 4 is connected to a tester computer 15 for determining whether the electronic devices D are defective or non-defective based on the signals from the electronic devices D. The tester 4 can reproduce the circuit configuration of multiple types of motherboards by replacing the test board. The probe card 12 has the plurality of probes 12a to be in contact with the plurality of electrode portions E of the electronic devices D. The tester 4 has a plurality of detection devices for detecting the electrical characteristics of the electronic devices D. As a result, the tester 4 detects the electrical characteristics of the electronic devices D.

The inspection system 1 includes a user interface part 16 for displaying information to a user or for allowing a user to input instructions. The user interface part 16 includes an input part such as a touch panel or a keyboard, and a display part such as a liquid crystal display, for example.

As described above, the inspection system 1 includes the stage 10 serving as a substrate holder for holding the substrate W. The inspection system 1 further includes the probe card 12 having the probes 12a, the interface 13, and the tester 4, as the detection part for detecting the electrical characteristics of the electronic devices D by supplying an inspection power to the electrode portions E of the electronic devices D on the substrate W.

The loader 3 includes a temperature control unit 14. The temperature control unit 14 has a power supply 25, a chiller 26, and a controller 90.

The stage 10 is provided with a heater 20 for heating the stage 10. The power supply 25 supplies a power to the heater 20 in the stage 10. A coolant channel 10a through which a heat transfer medium (antifreeze or the like) flows is formed in the stage 10. The chiller 26 circulates the heat transfer medium of which temperature has been adjusted through the coolant channel 10a. The inspection system 1 includes the heater 20, the power supply 25, the coolant channel 10a, and the chiller 26, as a temperature control mechanism for controlling the temperature of the substrate holder. The configuration of the temperature control mechanism is not limited thereto.

The temperature control mechanism includes a temperature detector 30 for detecting the temperature of the substrate holder. The temperature detector 30 is provided at the stage 10, and detects a temperature $T_{stage}$ of the stage 10. The temperature $T_{stage}$ of the stage 10 detected by the temperature detector 30 is inputted to the controller 90.

The tester 4 includes a power detector 41 for detecting the inspection power (current and voltage) supplied from the tester 4 to the electronic devices D via the interface 13 and the probe card 12. The inspection power detected by the power detector 41 is inputted to the controller 90.

The tester 4 includes a temperature estimation part 42 for detecting a junction temperature $T_j$ that is the temperature of the junction portion of the electronic devices D from the correlation between the generated electromotive force and the temperature by causing a current to flow through PN junction (junction portion, e.g., transistor) formed in the electronic devices D. The junction temperature $T_j$ detected by the temperature estimation part 42 is inputted to the controller 90.

The controller 90 has a holder temperature controller 91 and an offset temperature determining part 92. The controller 90 controls the temperature control mechanism such that the junction temperature $T_j$ (temperature of the substrate W) of the electronic devices D becomes the inspection temperature.

The holder temperature controller 91 controls the temperature control mechanism such that the temperature Tstage of the substrate holder detected by the temperature detector 30 becomes the control temperature or the offset control temperature. In other words, the holder temperature controller 91 controls the power supply 25 to control the heat generation amount of the heater 20, thereby controlling the temperature Tstage of the stage 10. The holder temperature controller 91 may control the chiller 26 to control the temperature of the heat transfer medium supplied by the chiller 26 to the coolant channel 10a, thereby controlling the temperature Tstage of the stage 10.

The offset temperature determining part 92 determines the offset temperature of the control temperature according to the test pattern and/or the inspection power. As a result, during the inspection, the holder temperature controller 91 controls the temperature control mechanism such that the temperature Tstage of the substrate holder detected by the temperature detector 30 becomes the offset control temperature.

The offset temperature determining part 92 acquires the inspection power to be supplied to the electronic devices D. For example, the offset temperature determining part 92 acquires the inspection power to be supplied to the electronic devices D by inputting the inspection power detected by the power detector 41. The offset temperature determining part 92 may acquire the inspection power to be supplied to the electronic devices D by inputting the inspection power recorded in the test pattern of the electronic devices D from the tester computer 15.

Next, the substrate W to be inspected in the above-described inspection system 1 will be described with reference to FIG. 3. FIG. 3 is a plan view schematically showing the configuration of the substrate W.

By performing etching or wiring processing on a substantially circular silicon substrate, the plurality of electronic devices D are formed on the surface of the substrate W at predetermined intervals, as shown in FIG. 3. The electrode portions E are formed on the surfaces of the electronic devices D, i.e., the substrate W, and the electrode portions E are electrically connected to circuit elements in the electronic devices D. By applying a voltage to the electrode portions E, the current can flow through the circuit elements in the electronic devices D.

Here, when the electronic devices D such as a logic IC and the like are inspected, the temperature estimation part 42 for detecting the junction temperature Tj may not be able to appropriately detect the junction temperature Tj due to the influence of noise or the like under the conditions where a clock is generated.

Further, when the electronic devices D are inspected, the temperature difference occurs between the temperature Tstage of the stage 10 and the junction temperature Tj of the electronic devices D due to the thermal resistance between the stage 10 and the substrate W (electronic devices D). Therefore, when the electronic devices D are inspected by controlling the temperature such that the temperature Tstage of the stage 10 becomes the inspection temperature, the junction temperature Tj of the electronic devices D may be higher than the inspection temperature. In other words, the electronic devices D are inspected at a temperature higher than the inspection temperature, which may reduce the yield of the electronic devices D.

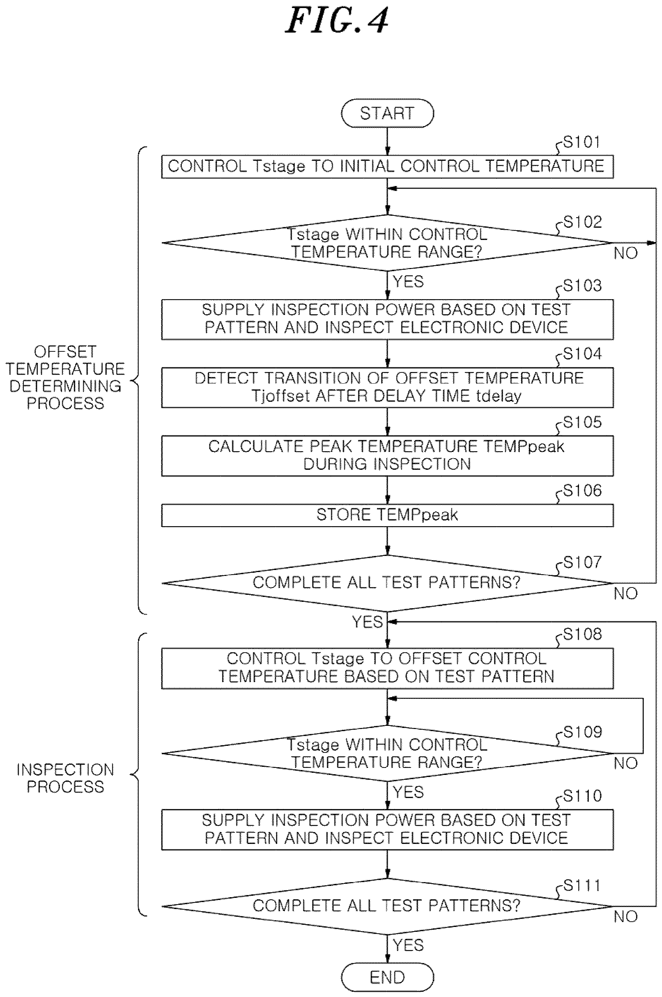

Next, the temperature control in the inspection system 1 according to the present embodiment will be described with reference to Figs. 4 to 6. FIG. 4 is an example of a flowchart for explaining the temperature control in the inspection system 1.

First, the offset temperature determining process will be described using steps S101 to S107. In the offset temperature determining process, the offset temperature of the control temperature of the substrate holder is determined.

In step S101, the holder temperature controller 91 controls the temperature Tstage of the substrate holder to the initial control temperature. In other words, the holder temperature controller 91 controls the temperature control mechanism such that the temperature Tstage of the substrate holder detected by the temperature detector 30 reaches the control temperature. The initial control temperature may be, for example, the inspection temperature.

In step S102, the holder temperature controller 91 determines whether or not the temperature Tstage of the substrate holder detected by the temperature detector 30 is within a predetermined control temperature range including the initial control temperature. If the temperature Tstage is not within the control temperature range (NO in S102), the process of step S102 is repeated. If the temperature Tstage is within the control temperature range (YES in S102), the processing of the controller 90 proceeds to step S103. In the subsequent processes (steps S103 to S104), the holder temperature controller 91 controls the temperature control mechanism such that the temperature Tstage is maintained within the predetermined control temperature range.

In step S103, the tester 4 supplies an inspection power to the electrode portions E of the electronic devices D based on the test pattern, and performs the inspection of electrical characteristics of the electronic devices D.

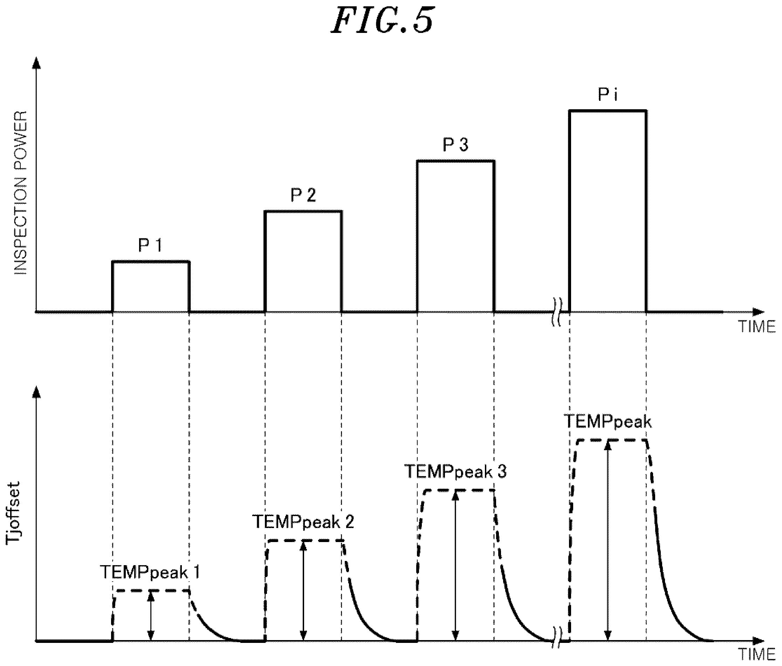

FIG. 5 is an example of a graph showing the temporal transition of the inspection power and the offset temperature Tjoffset of the electronic devices D. In FIG. 5, the upper graph shows an example of a test pattern of the inspection power supplied to the electronic devices D. The vertical axis represents the inspection power supplied to the electronic devices D. The horizontal axis represents time. The lower graph shows an example of the offset temperature Tjoffset of the electronic devices D. The vertical axis represents the offset temperature Tjoffset of the electronic devices D. The horizontal axis represents time. Here, the offset temperature Tjoffset of the electronic devices D is the offset temperature of the junction temperature Tj of the electronic devices D with respect to the inspection temperature. In other words, the offset temperature Tjoffset of the electronic devices D is the temperature obtained by subtracting the inspection temperature from the junction temperature Tj of the electronic devices D.

The test pattern includes multiple types of inspection with different inspection powers. In the example shown in FIG. 5, the test pattern includes first inspection performed with an inspection power P1, second inspection performed with an inspection power P2, third inspection performed with an inspection power P3, ..., i-th inspection (i being an arbitrary integer) performed with an inspection power Pi.

By supplying the inspection power to the electronic devices D, the electronic devices D generates heat, and the temperature of the electronic devices D increases. In other words, the junction temperature Tj of the electronic devices D increases, and the offset temperature Tjoffset of the electronic devices D also increases. Further, by ending the inspection and stopping the supply of the inspection power, the temperature of the electronic devices D decreases. In other words, the junction temperature Tj of the electronic devices D decreases, and the offset temperature Tjoffset of the electronic devices D also decreases.

Here, in the inspection of the electronic devices D, the temperature estimation part 42 cannot detect the junction temperature Tj of the electronic devices D. Therefore, in FIG. 5, the offset temperature Tjoffset of the electronic devices D in the section where the junction temperature Tj cannot be detected is indicated by a dashed line.

In step S103, the tester 4 supplies the inspection power P1 to the electronic devices D based on the test pattern, and inspects the electrical characteristics of the electronic devices D. The offset temperature determining part 92 acquires the inspection power P1 supplied to the electronic devices D in the inspection of the electronic devices D shown in step S103. When the inspection of the electrical characteristics of the electronic devices D is completed, the tester 4 stops the supply of the inspection power P1.

In step S104, the offset temperature determining part 92 acquires information on the junction temperature Tj after delay time tdelay. Specifically, the offset temperature determining part 92 detects (acquires) the transition of the junction temperature Tj from the temperature estimation part 42 after the delay time tdelay. As a result, the offset temperature determining part 92 detects (acquires) the transition of the offset temperature Tjoffset of the electronic devices D after the delay time tdelay.

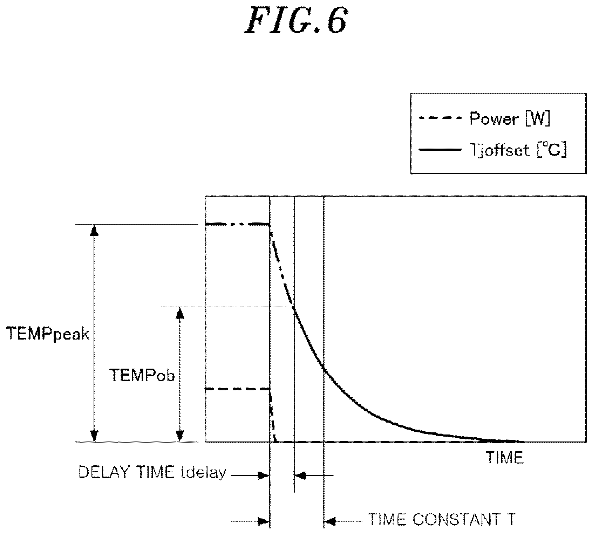

FIG. 6 is an example of a graph showing the temporal transition of the inspection power and the offset temperature Tjoffset of the electronic devices D before and after the inspection of the electronic devices D is completed. In FIG. 6, the vertical axis represents the offset temperature Tjoffset of the electronic devices D and the inspection power supplied to the electronic devices D. The horizontal axis represents time. In FIG. 6, the offset temperature Tjoffset of the electronic devices D in the detected range (after the delay time tdelay) is indicated by a solid line. In addition, the offset temperature Tjoffset of the electronic devices D in the non-detected range (before the delay time tdelay) is indicated by a dashed double-dotted line. The inspection power supplied to the electronic devices D is indicated by a dashed line.

After the delay time tdelay has elapsed from the stop of the supply of the inspection power, the offset temperature determining part 92 detects the transition of the junction temperature Tj of the electronic devices D by the temperature estimation part 42. Then, the offset temperature determining part 92 detects the transition of the offset temperature Tjoffset of the electronic devices D from the difference between the junction temperature Tj and the inspection temperature. As a result, as shown in FIG. 6, the transition in which the offset temperature Tjoffset of the electronic devices D decreases is detected.

In step S105, the offset temperature determining part 92 calculates a peak temperature TEMPpeak during the inspection. Here, the peak temperature TEMPpeak is the offset temperature Tjoffset of the electronic devices D during the inspection. In other words, the peak temperature TEMPpeak is the increase in the junction temperature Tj of the electronic devices D with respect to the inspection temperature during the inspection. In other words, the peak temperature TEMPpeak is the temperature obtained by subtracting the inspection temperature from the junction temperature Tj of the electronic devices D during the inspection.

Here, the offset temperature Tjoffset at the time of stopping the supply of the inspection power is calculated as the peak temperature TEMPpeak. The system in which the offset temperature Tjoffset of the electronic devices D decreases after the supply of the inspection power is stopped is represented as a first-order lag system. The offset temperature determining part 92 calculates a time constant T by the least square method or the like from the transition of the offset temperature Tjoffset of the electronic devices D detected in step S104.

Then, the offset temperature determining part 92 calculates the peak temperature TEMPpeak by the following formula based on the delay time tdelay, the calculated time constant T, and the observed temperature TEMPob at the delay time.

$$TEMPpeak = TEMPob \cdot exp(tdelay/T)$$

In step S105, the peak temperature TEMPpeak1 (see FIG. 5) in the case of inspecting the electronic devices D with the inspection power P1 (see FIG. 5) is calculated.

In step S106, the offset temperature determining part 92 stores the peak temperature TEMPpeak in a memory part (not shown).

In step S106, the offset temperature determining part 92 determines the peak temperature TEMPpeak1 as the offset temperature of the substrate holder in the case of inspecting the electronic devices D with the inspection power P1 (see FIG. 5), and stores the inspection power P1 and the peak temperature TEMPpeak1 (offset temperature of the substrate holder) in association with each other in the memory part.

In step S107, the controller 90 determines whether or not all the test patterns have been completed. If all the test patterns have not been completed (No in S107), the controller 90 returns to step S102 and repeats the processes from step S102 to step S106. As a result, in the second inspection and subsequent inspections performed with the inspection power P2, the inspection power and the peak temperature TEMPpeak (offset temperature of the substrate holder) are associated with each other and stored in the memory part.

When all the test patterns have been completed (YES in S107), the controller 90 ends the offset temperature determining process (steps S101 to S107).

The inspection power and the peak temperature TEMPpeak (offset temperature of the substrate holder) may be stored as a table in the memory part. The offset temperature determining part 92 may generate a function indicating the relationship between the inspection power and the peak temperature TEMPpeak (offset temperature of the substrate holder) from the information stored in the table, and the generated function may be stored in the memory part.

Next, the inspection process will be described using steps S108 to S111. In the inspection process, the control temperature of the substrate holder is offset by the offset temperature determined in the offset temperature determining process to inspect the electronic devices D.

In step S108, the holder temperature controller 91 controls the temperature Tstage of the substrate holder by the offset control temperature. In other words, the holder temperature controller 91 controls the temperature control mechanism such that the temperature Tstage of the substrate holder detected by the temperature detection part 30 reaches the offset control temperature.

For example, a configuration in which the tester sends an instruction to the controller 90 will be described. The tester 4 transmits, to the controller 90, the offset temperature of the substrate holder corresponding to the inspection power of the inspection to be performed next according to the test pattern (peak temperature TEMPpeak stored in step S106). The controller 90 controls the temperature control mechanism to a temperature obtained by subtracting the offset temperature of the substrate holder from the initial control temperature.

The tester 4 may be configured to transmit, to the controller 90, the inspection power of the inspection to be performed next according to the test pattern. In this case, the controller 90 determines the offset temperature of the substrate holder corresponding to the inspection power (peak temperature TEMPpeak stored in step S106) and controls the temperature control mechanism to a temperature obtained by subtracting the offset temperature from the initial control temperature.

Further, the inspection power detected by the power detector 41 may be transmitted to the controller 90. In this case, the controller 90 determines the offset temperature of the substrate holder corresponding to the inspection power (peak temperature TEMPpeak stored in step S106) and controls the temperature control mechanism to a temperature obtained by subtracting the offset temperature from the initial control temperature.

In step S109, the holder temperature controller 91 determines whether or not the temperature Tstage of the substrate holder detected by the temperature detector 30 is within a predetermined control temperature range including the offset control temperature. If the temperature Tstage is not within the control temperature range (NO in S109), the process of step S109 is repeated. If the temperature Tstage is within the control temperature range (YES in S109), the processing of the controller 90 proceeds to step S110. In the subsequent process (step S110), the holder temperature controller 91 controls the temperature control mechanism such that the temperature Tstage is maintained within the predetermined control temperature range. In the subsequent process (step S109), the holder temperature controller 91 controls the temperature control mechanism such that the temperature Tstage is maintained within the predetermined control temperature range.

In step S110, the tester 4 supplies the inspection power to the electronic devices D based on the test pattern, and inspects the electrical characteristics of the electronic devices D.

In the inspection shown in step S110, the temperature Tstage of the substrate holder is offset, so that the temperature of the electronic devices D during the inspection can become close to the inspection temperature.

In step S111, the controller 90 determines whether or not all the test patterns have been completed. If all the test patterns have not been completed (NO in S111), the controller 90 returns to step S108 and repeats the processes from step S108 to step S110. If all the test patterns have been completed (S111, YES), the controller 90 ends the inspection process (steps S108 to S111).

As described above, the controller 90 can estimate the peak temperature TEMPpeak during the inspection based on the temperature change of the electronic devices D after the inspection. Accordingly, the junction temperature Tj during the inspection can be estimated.

In addition, in the offset temperature determining process, the controller 90 estimates the peak temperature TEMPpeak during the inspection and stores it as the offset temperature of the substrate holder. Then, in the inspection process, the controller 90 controls the temperature of the substrate holder to the control temperature offset by the offset temperature. Accordingly, in the case of inspecting the electronic devices D, the electronic devices D can be set to the inspection temperature, and the inspection can be performed appropriately. In addition, a decrease in the yield of the electronic devices D can be prevented.

In addition, the packaging cost of the electronic devices D can be reduced compared to the configuration in which the electrode portions E used only for detecting the junction temperature Tj are provided at the electronic devices. In addition, the number of probes 12a of the probe card 12 can be reduced.

While the inspection apparatus 1 has been described, the present disclosure is not limited to the above-described embodiments, and various changes and modifications can be made without departing from the scope of the appended claims and the gist thereof.

This application claims priority to Japanese Patent Application No. 2023-4559 filed on January 16, 2023, the entire contents of which are incorporated herein by reference.

**Description of Reference Numerals**

| W: | substrate |
|---|---|
| D: | electronic device |
| E: | electrode portion |
| 1: | inspection system |
| 2: | accommodating chamber |
| 3: | loader |
| 4: | tester |
| 10: | stage |
| 10a: | coolant channel |
| 12: | probe card |
| 12a: | probe |
| 13: | interface |
| 14: | temperature control unit |
| 20: | heater |
| 25: | power supply |
| 26: | chiller |
| 30: | temperature detector |
| 41: | power detector |
| 42: | temperature estimation part |
| 50: | temperature control mechanism |
| 55: | power supply |
| 90: | controller |
| 91: | holder temperature controller |
| 92: | offset temperature determining part |

**Claims**

1. An inspection system configured to inspect a substrate while performing temperature control using a temperature control mechanism, comprising:

   a substrate holder configured to hold the substrate;
   a detector configured to supply an inspection power to an electrode portion of the substrate; and
   a controller,
   wherein the detector includes:
   a temperature estimation part configured to estimate a junction temperature of a junction portion provided at the substrate, and
   the controller includes:

   supplying the inspection power to the substrate;
   acquiring information on the junction temperature after the supply of the inspection power is stopped;
   determining an offset temperature of the substrate holder based on the information on the junction temperature;
   adjusting the temperature of the substrate holder based on a control temperature offset by the offset temperature; and
   supplying the inspection power to the substrate to inspect the substrate after the temperature of the substrate holder is adjusted.

2. The inspection system of claim 1, wherein said acquiring information on the junction temperature includes:
   acquiring transition of an offset temperature of the junction temperature, which is a difference between the junction temperature and the inspection temperature of the substrate.

3. The inspection system of claim 2, wherein said determining the offset temperature of the substrate holder includes:

   estimating the offset temperature of the junction temperature at the time of stopping the supply of the inspection power based on the transition of the offset temperature of the junction temperature; and
   determining the offset temperature of the substrate holder based on the estimated offset temperature of the junction temperature at the time of stopping the supply of the inspection power.

4. The inspection system of claim 1, wherein the temperature control mechanism is configured to detect the temperature of the substrate holder and adjust the temperature of the substrate holder.

5. The inspection system of claim 1, wherein the detector has a detection device configured to detect a plurality of electrical characteristics.

6. The inspection system of claim 1, wherein the substrate includes:

the electrode portion; and
an electronic device connected to the electrode portion, and
wherein the detector is configured to detect electrical characteristics of the electronic devices to which the inspection power is supplied.

7. A temperature control method for an inspection system for inspecting a substrate while performing temperature control using a temperature control mechanism,

wherein the inspection system includes:

a substrate holder configured to hold the substrate;
a detector that has a temperature estimation part configured to estimate a junction temperature of a junction portion provided at the substrate and is configured to supply an inspection power to an electrode portion of the substrate,

the method comprising:

supplying the inspection power to the substrate;
acquiring information on the junction temperature after the supply of the inspection power is stopped;
determining an offset temperature of the substrate holder based on the information on the junction temperature;
adjusting the temperature of the substrate holder based on a control temperature offset by the offset temperature; and
supplying the inspection power to the substrate and inspecting the substrate after the temperature of the substrate holder is adjusted.

8. The temperature control method of claim 7, wherein said acquiring information on the junction temperature includes:
acquiring transition of an offset temperature of the junction temperature, which is a difference between the junction temperature and the inspection temperature of the substrate.

9. The temperature control method of claim 8, wherein said determining the offset temperature of the substrate holder includes:

estimating the offset temperature of the junction temperature at the time of stopping the supply of the inspection power based on transition of the offset temperature of the junction temperature; and
determining the offset temperature of the substrate holder based on the estimated offset temperature of the junction temperature at the time of stopping the supply of the inspection power.

# FIG.1

# FIG.2

# FIG.3

# FIG.4

START

S101
CONTROL Tstage TO INITIAL CONTROL TEMPERATURE

S102
Tstage WITHIN CONTROL TEMPERATURE RANGE? — NO

YES

OFFSET TEMPERATURE DETERMINING PROCESS

S103
SUPPLY INSPECTION POWER BASED ON TEST PATTERN AND INSPECT ELECTRONIC DEVICE

S104
DETECT TRANSITION OF OFFSET TEMPERATURE Tjoffset AFTER DELAY TIME tdelay

S105
CALCULATE PEAK TEMPERATURE TEMPpeak DURING INSPECTION

S106
STORE TEMPpeak

S107
COMPLETE ALL TEST PATTERNS? — NO

YES

INSPECTION PROCESS

S108
CONTROL Tstage TO OFFSET CONTROL TEMPERATURE BASED ON TEST PATTERN

S109
Tstage WITHIN CONTROL TEMPERATURE RANGE? — NO

YES

S110
SUPPLY INSPECTION POWER BASED ON TEST PATTERN AND INSPECT ELECTRONIC DEVICE

S111
COMPLETE ALL TEST PATTERNS? — NO

YES

END

*FIG.5*

# FIG.6

## INTERNATIONAL SEARCH REPORT

| International application No. |
| --- |
| **PCT/JP2024/000189** |

| A. | CLASSIFICATION OF SUBJECT MATTER |
| --- | --- |

*H01L 21/66*(2006.01)i; *G01R 31/26*(2020.01)i; *G01R 31/28*(2006.01)i
FI:    H01L21/66 B; G01R31/28 H; G01R31/26 G

According to International Patent Classification (IPC) or to both national classification and IPC

| B. | FIELDS SEARCHED |
| --- | --- |

Minimum documentation searched (classification system followed by classification symbols)

H01L21/66; G01R31/26; G01R31/28

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | WO 2021/014724 A1 (TOKYO ELECTRON LIMITED) 28 January 2021 (2021-01-28) paragraphs [0011]-[0047], fig. 2, 4 | 1-9 |
| A | JP 2019-204871 A (TOKYO ELECTRON LIMITED) 28 November 2019 (2019-11-28) | 1-9 |
| A | JP 2017-120838 A (MITSUBISHI ELECTRIC CORPORATION) 06 July 2017 (2017-07-06) | 1-9 |

☐ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **19 March 2024** | **02 April 2024** |

| Name and mailing address of the ISA/JP | Authorized officer |
| --- | --- |
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (July 2022)

## INTERNATIONAL SEARCH REPORT
### Information on patent family members

| International application No. |
| --- |
| **PCT/JP2024/000189** |

| Patent document cited in search report | | | Publication date (day/month/year) | Patent family member(s) | | | Publication date (day/month/year) |
| --- | --- | --- | --- | --- | --- | --- | --- |
| WO | 2021/014724 | A1 | 28 January 2021 | US | 2022/0262661 | A1 | |
| | | | | paragraphs [0028]-[0088], fig. 2, 4 | | | |
| | | | | JP | 2021-19066 | A | |
| | | | | CN | 114096933 | A | |
| | | | | KR | 10-2022-0034173 | A | |
| | | | | TW | 202117478 | A | |
| JP | 2019-204871 | A | 28 November 2019 | US | 2021/0208194 | A1 | |
| | | | | WO | 2019/225332 | A1 | |
| | | | | EP | 3799111 | A1 | |
| | | | | CN | 112119487 | A | |
| | | | | KR | 10-2021-0010511 | A | |
| JP | 2017-120838 | A | 06 July 2017 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019122107 A
- JP 2023004559 A